Europäisches Patentamt

European Patent Office

Office européen des brevets

(19)

(11) **EP 0 712 133 B1**

(12) **FASCICULE DE BREVET EUROPEEN**

(45) Date de publication et mention
de la délivrance du brevet:
**10.12.1997 Bulletin 1997/50**

(51) Int Cl.⁶: **G11C 8/00**, G11C 7/00,
G11C 11/00

(21) Numéro de dépôt: **95470040.7**

(22) Date de dépôt: **30.10.1995**

(54) **Procédé de lecture anticipée de mémoire à accès série et mémoire s'y rapportant**

Verfahren zum vorzeitigen Lesen eines seriellen Zugriffspeichers und entsprechender Speicher

Method of anticipated reading of a serial accessed memory and related memory

(84) Etats contractants désignés:
**DE FR GB IT**

(30) Priorité: **10.11.1994 FR 9413672**

(43) Date de publication de la demande:
**15.05.1996 Bulletin 1996/20**

(73) Titulaire: **SGS-THOMSON MICROELECTRONICS
S.A.
94250 Gentilly (FR)**

(72) Inventeur: **Tailliet, François
F-57000 Metz (FR)**

(74) Mandataire: **Schmit, Christian Norbert Marie
Cabinet Ballot-Schmit,
18 Place du Forum
57000 Metz (FR)**

(56) Documents cités:
**EP-A- 0 299 697        US-A- 5 093 805**

**Description**

L'invention concerne les mémoires à accès série. Elle concerne plus particulièrement les mémoires non volatiles programmables et effaçables électriquement (plus connues sous le nom de mémoires EEPROM), bien qu'elle puisse s'appliquer par extension à d'autres types de mémoires volatiles ou non volatiles.

Le développement actuel des mémoires en circuit intégré de très grande capacité de mémorisation d'information (au sens du nombre d'informations mémorisées) s'est accompagné du désir d'augmenter les fréquences de signal d'horloge cadençant le fonctionnement des systèmes dans lesquels ces mémoires sont mises en oeuvre, et par conséquent de la recherche de temps d'accès toujours plus courts au contenu des mots constituant ces mémoires. Par mot, on entend une entité physique dont le contenu est représentatif d'une information binaire codée sur b bits, b nombre entier. Typiquement, ces mots seront donc formés de b cellules de mémorisation élémentaires, chaque cellule élémentaire étant constituée typiquement d'un circuit de mémorisation.

Du point de vue du temps d'accès, les mémoires à accès parallèle sont les plus avantageuses, une durée correspondant à une période du signal d'horloge cadençant le fonctionnement d'une telle mémoire étant suffisante pour fournir en parallèle à une de ces mémoires l'adresse d'un de ses mots dont on désire lire le contenu.

Néanmoins, les mémoires à accès série ont par ailleurs des avantages certains par rapport aux mémoires à accès parallèle, tels qu'un coût de fabrication moindre et surtout un encombrement et un poids de boîtier nettement plus faibles. En effet, les mémoires à accès série nécessitent un nombre de broches de connexion beaucoup moins important, or le nombre de broches de connexion à un circuit intégré influence fortement l'encombrement de ce circuit. Les mémoires à accès série sont de ce fait particulièrement intéressantes dans des applications portables.

Il apparait par compte souhaitable de pouvoir accroître les fréquences de signal d'horloge et la capacité de mémorisation de ces mémoires à accès série. Les produits les plus performants actuellement ont des capacités de 64 kilobits, et travaillent à des fréquences de l'ordre de 1 mégahertz. Dans un proche avenir, des capacités de l'ordre de 256 kilobits et des fréquences de l'ordre de 5 mégahertz et plus sont envisageables.

En pratique, l'augmentation des fréquences de signal d'horloge de ces mémoires pose des problèmes techniques, liés essentiellement au temps d'accès en lecture au contenu des mots. Par temps d'accès en lecture, on entend le délai, vis à vis de l'extérieur, entre le moment où l'adresse d'un mot est connue de la mémoire (c'est à dire le moment où tous les bits de l'adresse de ce mot ont été reçues en série par la mémoire) et le moment où l'information binaire dont est représentatif le contenu des cellules du mot commence à être (si la mémoire est à sortie série) ou est (si la mémoire est à sortie parallèle ou si les informations sont codées sur un bit) disponible à l'extérieur de la mémoire, par le biais d'une ou plusieurs broches de sortie.

Le temps d'accès est limité essentiellement par le temps nécessaire pour enchaîner les deux étapes suivantes:

- décodage de l'adresse reçue par la mémoire, c'est à dire le positionnement de divers dispositifs de commutation qui connectent un circuit de lecture au mot dont le contenu est représentatif de l'information binaire à lire,

- processus de lecture proprement dit, c'est à dire l'extraction de l'information binaire, sous forme de signaux logiques, à partir du mot lu (les cellules du mot ne stockent pas forcément une information logique directement exploitable, mais présentent plus généralement une caractéristique physique variable qu'un circuit approprié, comprenant par exemple un amplificateur différentiel, transformera en signal logique).

Classiquement, l'adresse, codée sur un certain nombre de bits, est reçue en série dans un registre à décalage, ce processus durant autant de périodes de signal d'horloge qu'il y a de bits d'adresse à recevoir.

Le temps d'accès maximal admissible est souvent égal à la durée d'un nombre impair de demi-périodes de signal d'horloge. Par exemple ce temps d'accès est fixé à trois demi-périodes dans le cas où la mémoire est connectée à un bus de type Microwire ou I2C, et il est fixé à une demi-période si la mémoire est connectée à un bus SPI.

Le type de bus par lequel la mémoire communique avec d'autres dispositifs fixe donc le temps d'accès maximal admissible pour une fréquence de signal d'horloge donnée. Par exemple, si on souhaite utiliser un bus SPI et une fréquence de signal d'horloge de 2 mégahertz, le temps d'accès admissible est limité à 250 nanosecondes, ce qui est une performance proche de celles des dispositifs de lecture des mémoires à accès parallèle rapide.

On se heurte alors à des difficultés techniques de réalisation inhérentes aux vitesses de commutation requises. Dans le cas où une solution est trouvée, les circuits utilisés ont souvent une consommation élevée, ce qui est peu souhaitable pour des mémoires souvent destinées à des applications portables, dans lesquelles une consommation minimale est recherchée. En pratique, c'est donc la fréquence du signal d'horloge qui est déterminée par rapport au type de bus utilisé et au temps d'accès maximal admissible envisagé.

La demande de brevet US-A-5093805 divulgue une mémoire de type FIFO utilisant un plan mémoire en deux parties, chacune associée à un décodeur de colonnes suivi par un circuit de lecture et comportant en sortie un multiplexeur pour extraire l'information binaire.

Le but de l'invention est de proposer une solution aux difficultés techniques évoquées ci-dessus en proposant un procédé de lecture et une organisation de mémoire à accès série qui allie simplicité technique, consommation réduite, et fonctionnellement similaires vis à vis de l'extérieur au procédé de lecture et à l'organisation classiques d'une mémoire à accès série de type connu.

L'invention propose ainsi un procédé de lecture du contenu de mots d'une mémoire en circuit intégré, cette mémoire étant organisée matriciellement en mots, le contenu de chaque mot étant représentatif d'une information binaire, chaque mot étant accessible à une adresse particulière codée en binaire sur k bits, k nombre entier supérieur à 1, les bits d'adresse étant reçues en série par la mémoire sur une borne d'entrée d'adresse, caractérisé en ce que la lecture du contenu d'un mot comprend les étapes suivantes :

- réception en série des q premiers bits de l'adresse du mot à lire, avec q nombre entier inférieur à k,
- parallèlement à la réception des k-q derniers bits de l'adresse :
- décodage des q premiers bits de l'adresse reçus et connexion de circuits de lecture aux mots dont les q premiers bits d'adresse correspondent aux q premiers bits d'adresse reçus,
- extraction des informations binaires dont sont représentatifs les contenus de ces dits mots,
- décodage des k - q derniers bits de l'adresse de la cellule à lire et fourniture sur une borne de sortie de donnée de la mémoire de l'information binaire dont est représentatif le contenu du mot dont les bits d'adresse correspondent aux k bits d'adresse reçus.

Suivant l'invention, on propose donc de commencer le décodage d'adresse et la lecture alors que les bits d'adresse n'ont pas encore tous été reçus. On augmente ainsi de manière interne le temps d'accès interne maximal admissible (c'est à dire le délai maximal pour le décodage d'adresse et la lecture des mots) en nombre de demi-périodes de signal d'horloge, le temps d'accès maximal admissible, vu de l'extérieur de la mémoire, restant identique, pour une fréquence donnée. Le temps d'accès vu de l'extérieur n'est donc plus imposé par la durée de mise en oeuvre des opérations de décodage d'adresse et de lecture, mais peut être inférieur à celle-ci. Cela permet donc d'augmenter la fréquence du signal d'horloge admissible à temps d'accès maximal identique. Parallèlement, le décodage commençant alors que tous les bits d'adresse n'ont pas été reçus, on activera en parallèle plusieurs circuits de lecture pour extraire les informations de tous les mots dont les bits d'adresse correspondent aux bits reçus quand le décodage commence. On sélectionnera l'information à fournir en sortie une fois l'adresse complète connue. Il s'agira alors d'une simple opération d'aiguillage de durée brève devant les opérations de décodage et de lecture proprement dite, le temps d'accès étant principalement limité par la lenteur d'opérations analogiques telles que l'utilisation d'amplificateurs de lecture.

L'invention concerne également une mémoire en circuit intégré, organisée en mots, le contenu de chaque mot étant représentatif d'une information binaire, chaque mot étant accessible à une adresse particulière codée en binaire sur k bits, k entier supérieur à 1, la mémoire comprenant une borne d'entrée d'adresse pour recevoir les bits d'adresse en série, une borne de sortie de donnée pour fournir les informations binaires correspondantes aux contenus des mots adressés, un registre d'entrée pour stocker des bits d'adresse reçus, des circuits de décodage des bits d'adresse reçus, des circuits de connexion des mots à des circuits de lecture, caractérisée en ce que les mots sont organisés en groupes de mots de telle manière que les mots de chaque groupe ont k - q derniers bits d'adresse identiques, avec q entier inférieur à k, et q premiers bits d'adresse distincts, chaque groupe de mots a un circuit de lecture associé pour, quand la mémoire reçoit k bits d'adresse, extraire l'information binaire dont est représentatif le contenu du mot du groupe correspondant aux q premiers bits d'adresse reçus, et la mémoire comprend des circuits de commande et de multiplexage de sortie pour fournir sur la borne de sortie de donnée l'information binaire dont est représentatif le contenu du mot dont l'adresse correspond aux k bits reçus.

Une telle mémoire met en oeuvre le procédé ci-dessus. Par rapport à une mémoire classique, la mémoire selon l'invention est un peu plus encombrante du fait de la présence de plusieurs circuits de lecture travaillant parallèlement. Par contre on remarquera la simplicité technique d'une telle mémoire dont le fonctionnement est globalement similaire à celui d'une mémoire classique. Pour une fréquence de signal d'horloge admissible plus élevée, on pourra utiliser des circuits de lecture de même type que dans une mémoire classique, c'est à dire qu'une consommation excessive sera imputable seulement au nombre plus élevé de circuits de lecture mais pas à une complexité accrue des circuits de la mémoire.

En pratique, le décodage de q premiers bits d'une adresse d'un mot à lire sera mis en oeuvre dans des circuits de décodage de ligne et de colonne de type classique. Le décodage des k - q derniers bits reçus correspondra à la production de signaux de commande de circuits de multiplexage et des circuits de lecture.

Dans un mémoire classique, on mémorise les bits d'adresse reçus dans un registre à décalage formé de k cellules, et relié à la borne d'entrée d'adresse. Pour les mémoires pouvant fonctionner en mode de lecture séquentielle, ce registre d'entrée est d'autre part agencé pour pouvoir fonctionner en compteur d'adresse binaire.

Dans une version préférée, l'invention prévoit de stocker d'une part les q premiers bits d'adresse et d'autre part les k - q derniers bits d'adresse. On utilise ainsi deux sous-registre à décalage de respectivement q et k - q cellules. Les deux sous-registres sont reliés à la borne d'entrée d'adresse. Cette solution permet de stocker les bits d'adresse d'un même rang toujours dans les mêmes cellules. Cela permet de mettre en oeuvre facilement l'invention. Il serait en effet beaucoup plus complexe d'utiliser un seul registre à décalage, car il est prévu de fournir les q premiers bits d'adresse dès la réception du $q^{ième}$ bit d'adresse. En utilisant un seul registre à décalage, le contenu des cellules de ce registre serait amené à être modifié, par décalage, alors que le décodage a lieu. En pratique, il serait donc nécessaire de prévoir un registre tampon entre le registre d'entrée et les circuits de décodage, afin de garantir la stabilité des q bits utilisés pour le décodage.

Par ailleurs, on ne pourra pas se contenter d'un seul registre d'entrée de q cellules, de type à décalage, directement relié à la borne d'entrée d'adresse. D'une part, il est nécessaire de pouvoir mémoriser les q premiers bits d'adresse reçus, pour assurer une stabilité des bits utilisés pour le décodage d'adresse. D'autre part, il est nécessaire également de pouvoir mémoriser les k - q derniers bits d'adresse reçus afin de pouvoir commander de manière certaine (si k - q > 1) et stable le circuit de multiplage de sortie.

Dans une version préférée, l'invention propose un procédé caractérisé en ce que la mémoire possède un mode de lecture dite séquentielle tel que suite à la lecture du contenu d'un premier mot correspondant à une première adresse, la mémoire fournit automatiquement sur la borne de sortie de donnée une seconde information binaire dont est représentatif le contenu d'un second mot de la mémoire.

Les mémoires à accès série proposent le plus souvent un tel mode de lecture dans lequel l'adresse reçue de l'extérieur est stockée dans un compteur d'adresse de sorte que, dès que l'information correspondant à l'adresse reçue a été fournie à l'extérieur, on modifie automatiquement l'adresse stockée afin de sortir successivement, sans intervention de l'extérieur, les informations correspondantes au contenu des mots suivants. En pratique, la modification de l'adresse est le plus souvent une incrémentation de celle-ci.

Parallèlement, l'invention propose une mémoire dans laquelle le registre d'entrée est un compteur d'adresse binaire.

Bien évidemment, contrairement au cas d'une mémoire classique, dans un mode de lecture séquentielle, on ne modifiera pas systématiquement le contenu des q cellules du sous-registre correspondant aux q premiers bits d'adresse. Ce contenu ne sera modifié que si le second mot a q premiers bits d'adresse différents de ceux du premier mot. Les k - q derniers bits d'adresse, mémorisés, servent à déterminer si la modification des q premiers bits d'adresse est nécessaire ou non.

D'autres caractéristiques et avantages apparaîtront à la lecture de la description détaillée qui suit et qui est faite en référence aux dessins annexés, dans lesquels :

- la figure 1 représente une configuration de mémoire réalisée selon l'invention,
- la figure 2 représente une autre configuration de mémoire réalisée selon l'invention, cette mémoire pouvant utiliser un mode de lecture séquentielle.

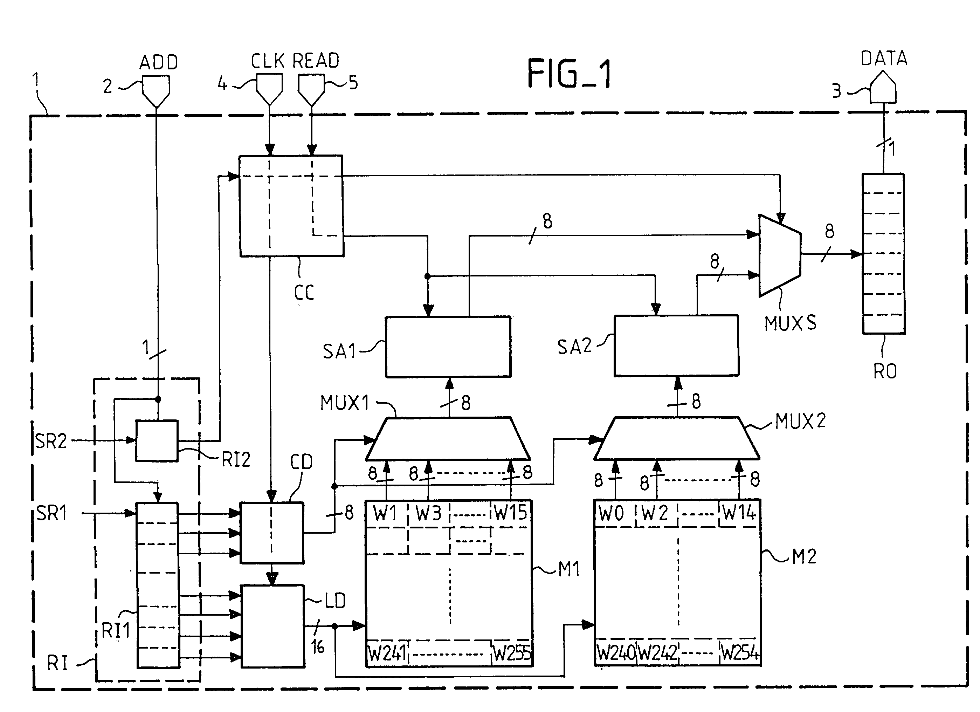

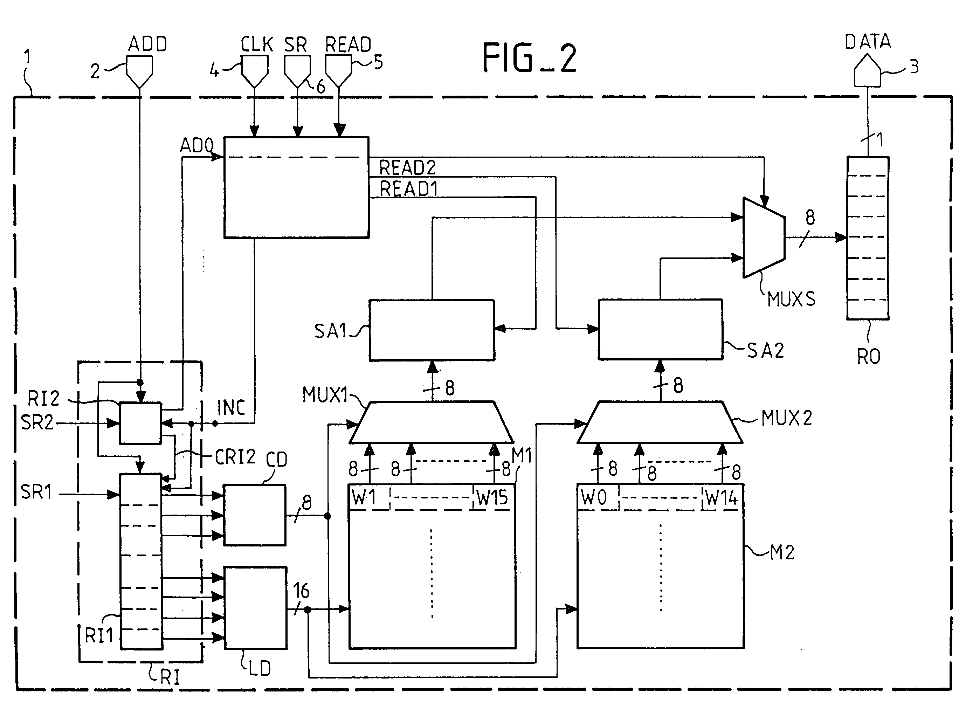

Dans les figures 1 et 2, on représente une mémoire 1 qui pourra par exemple être de type EEPROM et réalisée suivant une technologie en semi-conducteur connue.

On supposera par exemple que cette mémoire 1 est organisée en l lignes de m mots (W0 à W255) formés de b cellules élémentaires.

Classiquement, l, m et b seront des nombres entier égaux à des puissances de 2. On considérera dans la suite de la description que $l = m = 2^4 = 16$, et $b = 2^3 = 8$.

A chaque mot, on associera une adresse ADD codée sur k bits, tel que typiquement on aura $2^k = 1 * m$. Dans la description on supposera ainsi que k = 8, les quatre bits de poids les plus forts de l'adresse déterminant la ligne à laquelle on s'intéresse, et les quatre bits de poids les plus faibles de l'adresse déterminant quel mot on souhaite lire dans la ligne considérée.

Selon l'invention, on commence à décoder l'adresse ADD lorsqu'on aura reçu q = k - p premiers bits de cette adresse, avec q et p des entiers, et p < k. On a dans la mémoire $2^k$ mots. Pour q bits d'adresse donnés, il existe $2^p$ mots ayant leurs q premiers bits d'adresse égaux à ces q premiers bits d'adresse donnés. On va donc extraire $2^p$ informations binaires à partir des q premiers bits d'adresse reçus.

Les mots seront donc regroupées en $2^p$ groupes de mots, à chaque groupe étant associé un circuit de lecture, de telle manière à ce que dans chaque groupe :

- les mots ont q premiers bits d'adresse distincts,
- les mots ont p derniers bits d'adresse identiques.

Dans les exemples décrits on prendra p = 1.

Ainsi, pour une adresse ADD reçue en série, on commence le décodage de cette adresse alors que le bit de poids le plus faible n'est pas encore disponible en entrée. Cela implique, étant donné les hypothèses posées, que le décodage des premiers bits reçus permettra de déterminer de manière certaine la ligne à sélectionner, une indétermination subsistant sur le mot particulier que l'on souhaite lire. On pourra considérer, avec p = 1, que la mémoire est formée de deux demi-plans M1 et M2, chaque demi-plan étant formés de 16 lignes de 8 mots, le demi-plan M1 correspondant par exemple à un dernier bit d'adresse égal à 1, et l'autre demi-plan M2 correspondant alors à un dernier bit d'adresse égal à 0. Le plan mémoire est partagé en un demi-plan pair et un demi-plan impair.

La mémoire 1 comprend :

- une borne d'entrée d'adresse 2 pour recevoir en série l'adresse ADD d'un mot à lire,
- un registre d'entrée RI pour recevoir les bits d'adresse,
- une borne de sortie de donnée 3 pour fournir classiquement en série à l'extérieur les informations binaires, notées DATA, correspondantes aux adresses ADD reçues,
- une borne d'entrée 4 pour recevoir un signal d'horloge CLK supposé produit extérieurement à la mémoire 1, ce signal d'horloge CLK cadençant le fonctionnement de la mémoire 1,
- une borne d'entrée 5 pour recevoir un signal logique de commande de lecture READ (dans un exemple on lira les mots de la mémoire si READ = 1),
- un circuit de décodage de ligne LD pour sélectionner une ligne parmi les l de chaque demi-plan,
- un décodeur de colonne CD pour commander deux (soit $2^p$) multiplexeurs MUX1 et MUX2 et sélectionner par le biais de ceux-ci un mot à lire, par demi-plan, de la ligne sélectionnée par le décodeur de ligne LD,
- un circuit de commande CC non détaillé recevant le signal d'horloge CLK, le signal de commande de lecture READ, et fournissant des signaux de commande aux différents circuits de la mémoire afin d'assurer une synchronisation adéquate dans le fonctionnement de la mémoire 1,
- deux circuits de lecture SA1 et SA2, chacun étant associé à l'un des demi-plans M1 et M2, pour extraire deux informations binaires à partir des deux mots sélectionnés,
- un multiplexeur de sortie MUXS à $2^p$ entrées de type parallèle et une sortie de type parallèle pour sélectionner (selon des états de signaux de sélection reçus du circuit de commande CC) une des $2^p$ informations binaires extraites, en vue de fournir l'information extraite sélectionnée à l'extérieur,
- un registre de sortie RO. Typiquement, il s'agit d'un registre à décalage à entrée parallèle et sortie série. L'entrée du registre de sortie RO est reliée à la sortie du multiplexeur de sortie MUXS, et sa sortie est reliée à la borne de sortie 3. Selon les hypothèses retenues (informations codées sur b = 8 bits), ce registre de sortie RO sera bien sûr formé de huit cellules.

On ne détaillera pas de manière exhaustive la constitution logique des circuits, la réalisation de ceux-ci ne devant pas poser de problème particulier à un homme du métier, à partir de la description du fonctionnement donnée ci-dessous.

Le registre d'entrée RI est formé de deux sous-registres :

- un premier sous-registre RI1 à entrée série et sortie parallèle pour stocker les q premiers bits de l'adresse ADD reçue,

- un deuxième sous-registre RI2 (formé en l'occurence d'une seule cellule) à entrée série et sortie parallèle pour stocker les k - q derniers bits de l'adresse ADD reçue.

Les deux sous-registres RI1 et RI2 sont des registres à décalage, ayant leur entrée respective reliée à la borne d'entrée d'adresse 2.

Le sous-registre RI1 a sa sortie parallèle reliée aux circuits de décodage LD et CD. Quatre de ses cellules sont reliées au circuit de décodage de ligne LD, et les trois autres sont reliées au circuit de décodage de colonne CD. Il est à noter que par rapport à une mémoire classique de capacité équivalente, le circuit de décodage de colonne sera moins encombrant puisqu'il traitera trois bits au lieu de quatre.

Ce sous-registre RI1 reçoit un signal logique de commande de décalage SR1 (on admettra que le contenu des cellules passe d'une cellule à l'autre sur un front montant du signal d'horloge, si SR1 = 1).

Le sous-registre RI2 a sa sortie parallèle (en fait c'est une sortie série puisque k - q = 1) reliée au circuit de commande CC. On notera AD0 le contenu du sous-registre RI2. Il reçoit un signal logique de commande de décalage SR2 (on admettra que le contenu des cellules passe d'une cellule à l'autre sur un front montant du signal d'horloge, si SR2 = 1).

<u>Mémoire sans mode de lecture séquentielle (cas illustré figure 1).</u>

Lors de la réception des q premiers bits d'adresse, ceux-ci sont mémorisés dans le sous-registre RI1.

Lors de la réception des p derniers bits d'adresse, ceux-ci sont stockés dans le sous-registre RI2 (on maintient alors le signal de commande SR1 dans un état permanent égal à 0, empêchant ainsi au contenu du sous-registre RI1 d'être modifié).

La lecture d'un mot comprendra les étapes suivantes :

- réception en série (SR1 = 1) dans le premier sous-registre RI1 des sept premiers bits d'adresse du mot à lire,
- parallèlement à la réception du dernier bit d'adresse dans la cellule du deuxième sous-registre RI2 (SR2 = 1 et SR1 = 0) :
- décodage des sept premiers bits d'adresse reçus par les circuits de décodage de ligne et de colonne LD et CD, et connexion des circuit de lecture SA1 et SA2 respectivement aux mots des deux demi-plans M1 et M2 dont les sept premiers bits d'adresse correspondent aux sept premiers bits d'adresses reçus,
- extraction par le biais des circuits de lecture SA1 et SA2 des informations binaires dont sont représentatifs les contenus de ces deux mots,
- décodage du dernier bit d'adresse (AD0) par le circuit de commande CC (c'est à dire production d'un signal de sélection fourni au multiplexeur de sortie) et fourniture sur la borne de sortie de donnée 3 de l'information binaire dont est représentatif le contenu du mot dont l'adresse correspond aux huit bits d'adresse reçus, par le biais du multiplexeur de sortie MUXS et du registre de sortie RO. En pratique, pour p = 1, on pourra commander le multiplexeur de sortie MUXS directement en reliant son entrée de commande à la sortie du sous-registre RI2.

Le cas illustré figure 1 est surtout donné à titre d'exemple. En effet, la plupart des mémoires à accès série du commerce fonctionnent aussi en mode de lecture séquentielle.

Mémoire avec mode de lecture séquentielle (cas illustré figure 2).

Par rapport à la figure 1, on notera les différences suivantes :

- la mémoire comporte une borne d'entrée de commande 6 pour recevoir un signal logique de commande SR permettant d'entrer dans le mode de lecture séquentielle. On supposera que SR = 1 correspond à un mode de lecture séquentielle.
- le registre d'entrée RI peut fonctionner en compteur d'adresse binaire. Les premier et deuxième sous-registre RI1 et RI2 ne seront pas de simples registres à décalage. Le mode de lecture séquentielle suppose que le contenu des sous-registres RI1 et RI2 puisse être modifié de manière interne à la mémoire. Le registre d'entrée RI sera commandé par le circuit de commande CC (par le biais d'un signal logique de commande INC) pour modifier (typiquement incrémenter de 1) automatiquement le contenu du dit compteur (par exemple si le signal INC est à l'état logique 1).

Les sous-registres RI1 et RI2 reçoivent le signal logique de commande INC pour incrémenter leur contenu d'une unité (par exemple sur front montant de ce signal).

D'autre part, le sous-registre RI2 aura une sortie pour fournir un signal logique de retenue CRI2. Ce signal CRI2 passera dans un état donné, par exemple l'état 1, si suite à une incrémentation du contenu du sous-registre RI2, tous les bits stockés dans ce sous-registre sont à zéro. Cela correspond au cas où, avant incrémentation, tous les bits stockés dans ce sous-registre étaient à 1. Plus généralement, cela correspond au fait que si on souhaite lire le mot située à l'adresse suivant celle du mot lu avant incrémentation, il sera nécessaire de modifier le contenu du sous-registre RI1. Ainsi, on fournira, en plus du signal INC, le signal CRI2 au sous-registre RI1 de telle manière à ce que son contenu soit incrémenté uniquement si on a à la fois un front montant de INC et CRI2 = 1.

- les circuits de lecture SA1 et SA2 reçoivent chacun un signal de commande de lecture, noté respectivement READ1 et READ2.

On supposera que :

$$READ1 = SR \cdot READ \cdot AD0 + READ \cdot /SR,$$

$$READ2 = SR \cdot READ \cdot /AD0 + READ \cdot /SR,$$

et . représente un ET logique, + représente un OU logique, et / représente la complémentation.

Pour ce qui est de l'extraction de l'information à partir d'une adresse, on pourra distinguer deux cas, suivant que l'adresse est fournie à la mémoire par le biais de la borne d'entrée d'adresse 2 ou si elle est produite de manière interne.

1 - adresse reçue de l'extérieur.

Ce cas correspond à un type de fonctionnement analogue à celui illustré figure 1.

Pour la lecture du mot, de manière analogue au cas illustré figure 1, les q premiers bits sont utilisés par les circuits de décodage de ligne et de colonne LD et CD, et les p derniers bits sont utilisés par le circuit de commande CC.

Une fois les $2^p$ informations extraites des cellules lues (on aura bien entendu READ1 = READ2 = READ), l'information correspondant au k bits reçus est stockée dans le registre de sortie RO, par le biais du multiplexeur de sortie MUXS (sélection suivant AD0). On fournit ensuite par décalage dans le registre de sortie RO l'information sur la borne de sortie de donnée 3.

2 - lecture séquentielle.

En mode de lecture séquentielle, suite à la sortie d'une information correspondant à une première adresse donnée, cette adresse va être modifiée, sans intervention de l'extérieur, de manière à fournir successivement d'autres informations à l'extérieur.

On supposera que, classiquement, ladite première adresse sera incrémentée d'une unité afin de fournir l'information mémorisée dans le mot située à l'adresse suivante, et ainsi de suite.

On procédera selon les étapes suivantes :

- réception de l'extérieur des k bits d'adresse et sortie de l'information correspondante sur la borne de sortie de donnée,
- parallèlement à la sortie sur la borne de sortie de donnée de l'information :
- incrémentation d'une unité du contenu du deuxième sous-registre RI2, et incrémentation conditionnelle (en fonction de CRI2) du contenu du premier sous-registre RI1,

- décodage du contenu, après incrémentation, du sous-registre RI1,
- extraction de l'information désirée à l'aide du circuit de lecture approprié, SA1 ou SA2, en fonction du contenu AD0 du sous-registre RI2 après incrémentation, qui déterminera les états de READ1 et READ2.

On pourra pratiquer l'incrémentation par exemple quand la moitié des bits de l'information mémorisée dans le registre de sortie auront été effectivement fournies sur la borne de sortie de donnée. Ce qui compte est de ne pas attendre la sortie du dernier bit du registre de sortie avant de mettre en oeuvre la lecture suivante. Cela limiterait effectivement la fréquence d'horloge maximale admissible. Autrement dit, on s'arrangera avantageusement pour bénéficier, en mode de lecture séquentielle, d'un temps d'accès interne au moins égal au temps d'accès interne en mode de lecture non séquentielle (ou plus exactement quand l'adresse est fournie par l'extérieur).

Dans l'exemple illustré, supposons qu'on ait reçu de l'extérieur une première adresse d'un premier mot du demi-plan M2 (AD0 à 0). L'incrémentation de cette première adresse (AD0 passant à 1) donnera une seconde adresse d'un second mot, situé dans le demi-plan M1. Les q premiers bits de la première et de la seconde adresse seront identiques. Pour lire le contenu du second mot, les q bits stockés dans le sous-registre RI1 ne seront pas modifiés (CRI2 = 0). On aura READ1 = /READ2 = 1.

Pour la lecture du mot suivant, situé dans le demi-plan M2, on procédera de la manière suivante :

- incrémentation des contenus des sous-registre RI2 (on aura alors AD0 = 0, et CRI2 = 1) et RI1 (modification du $q^{ième}$ bit d'adresse et éventuellement d'un ou plusieurs des autres bits) par le biais du signal de commande INC,
- décodage par les circuits de décodage LD et CD des q bits stockés dans le sous-registre RI1 après incrémentation,
- lecture du mot correspondant à l'adresse après incrémentation à l'aide du circuit de lecture SA2 (READ2 = /READ1 = 1),
- stockages de l'information binaire extraite dans le registre de sortie,
- sortie de l'information.

Bien sûr, l'invention n'est pas limitée aux exemples qui viennent d'être décrits et on peut envisager d'autres aménagements et extensions sans sortir du cadre de l'invention. Ainsi, en particulier, on pourra regrouper les cellules de mémorisation en un nombre de groupes supérieur à 2 et augmenter ainsi le temps d'accès vu de l'intérieur de la mémoire, en augmentant par contre la consommation et l'encombrement de la mémoire.

Par ailleurs, on pourra envisager d'utiliser $2^p$ registres de sortie associés chacun à un des circuits de lecture, le multiplexeur de sortie étant placé entre ces registres de sortie et la borne de sortie de donnée. On pourra alors envisager, en mode de lecture séquentielle, de toujours lire $2^p$ mots et de sortir successivement ces mots sur la borne de sortie de donnée. On ne pratiquera alors une lecture effective des mots que si il y a une modification des q premiers bits d'adresse.

**Revendications**

1. Procédé de lecture du contenu de mots d'une mémoire (1) en circuit intégré, cette mémoire étant organisée matriciellement en mots (W0 à W255), le contenu de chaque mot étant représentatif d'une information binaire (DATA), chaque mot étant accessible à une adresse (ADD) particulière codée en binaire sur k bits, k nombre entier supérieur à 1, les bits d'adresse étant reçus en série par la mémoire sur une borne d'entrée d'adresse (2), caractérisé en ce que la lecture du contenu d'un mot comprend les étapes suivantes :

   - réception en série des q premiers bits de l'adresse du mot à lire, avec q nombre entier inférieur à k,
   - parallèlement à la réception des k-q derniers bits de l'adresse :

      - décodage des q premiers bits de l'adresse reçus et connexion de circuits de lecture (SA1, SA2) aux mots dont les q premiers bits d'adresse correspondent aux q premiers bits d'adresse reçus,
      - extraction des informations binaires dont sont représentatifs les contenus de ces dits mots,
      - décodage des k - q derniers bits de l'adresse du mot à lire et fourniture sur une borne de sortie de donnée (3) de la mémoire de l'information binaire dont est représentatif le contenu du mot dont les bits d'adresse correspondent aux k bits d'adresse reçus.

2. Procédé selon la revendication 1, caractérisé en ce que la mémoire possède un mode de lecture dite séquentielle tel que suite à la lecture du contenu d'un premier mot correspondant à une première adresse, la mémoire fournit automatiquement sur la borne de sortie de donnée une seconde information binaire dont est représentatif le contenu d'un second mot de la mémoire.

3. Procédé selon la revendication 2, caractérisé en ce que le décodage de l'adresse du second mot a lieu lors de la fourniture sur la borne de sortie de donnée de l'information binaire dont est représentatif le contenu du premier mot.

4. Procédé selon l'une des revendications 2 à 3, caractérisé en ce qu'en mode de lecture séquentielle, on extrait une information binaire à la fois.

5. Mémoire (1) en circuit intégré, organisée en mots (W0 à W255), le contenu de chaque mot étant représentatif d'une information binaire (DATA), chaque mot étant accessible à une adresse (ADD) particulière codée en binaire sur k bits, k entier supérieur à 1, la mémoire comprenant :

    - une borne d'entrée d'adresse (2) pour recevoir les bits d'adresse en série,
    - une borne de sortie de donnée (3) pour fournir les informations binaires correspondantes aux contenus des mots adressés,
    - un registre d'entrée (RI) pour stocker des bits d'adresse reçus,
    - des circuits de décodage (LD, CD) des bits d'adresse reçus,
    - des circuits de connexion (MUX1, MUX2) des mots à des circuits de lecture (SA1, SA2),

       caractérisée en ce que

    - les mots sont organisés en groupes de mots (M1, M2) de telle manière que les mots de chaque groupe ont k - q derniers bits d'adresse identiques, avec q entier inférieur à k, et q premiers bits d'adresse distincts,
    - chaque groupe de mots a un circuit de lecture associé pour, quand la mémoire reçoit k bits d'adresse, extraire l'information binaire dont est représentatif le contenu du mot du groupe correspondant aux q premiers bits d'adresse reçus, et
    - la mémoire comprend des circuits de commande (CC) et de multiplexage de sortie (MUXS) pour fournir sur la borne de sortie de donnée l'information binaire dont est représentatif le contenu du mot dont l'adresse correspond aux k bits reçus.

6. Mémoire selon la revendication 5, caractérisée en ce que le registre d'entrée (RI) est formé de deux sous-registres (RI1, RI2) à décalage formés respectivement de q et k - q cellules.

7. Mémoire selon la revendication 6, caractérisée en ce que le registre d'entrée (RI) est un compteur d'adresse binaire.

8. Mémoire selon la revendication 7, caractérisée en ce que le circuit de commande (CC) comprend des moyens pour modifier le contenu du registre d'entrée (RI).

9. Mémoire selon l'une des revendications 5 à 8, caractérisée en ce qu'elle comprend un registre de sortie (RO) relié aux circuits de lecture (SA1, SA2) pour stocker les informations binaires extraites par ces circuits de lecture.

10. Mémoire selon l'une des revendications 5 à 9, caractérisée en ce que c'est une mémoire électriquement programmable et effaçable.

## Claims

1. Method for reading the content of the words of an integrated circuit memory (1), this memory being organised in a matrix in words (W0 to W255), the content of each word representing an item of binary information (DATA), each word being accessible at a particular address (ADD) coded in binary over k bits, k being an integer number greater than 1, the address bits being received serially by the memory at an address input terminal (2), characterised in that the reading of the content of a word comprises the following steps:

    - serial reception of the first q bits of the address of the word to be read, with q being an integer number less than k,

    - in parallel to the reception of the last k-q bits of the address:

        - decoding of the first q bits of the address received and connection of read circuits (SA1, SA2) to the words whose first q address bits correspond to the first q address bits received,

        - extraction of the binary information which the contents of the said words represent,

        - decoding of the last k-q bits of the address of the word to be read and supply, at a data output terminal (3) of the memory, of the binary information represented by the content of the word whose address bits correspond to the k address bits received.

2. Method according to Claim 1, characterised in that the memory has a so-called sequential read mode such that, following the reading of the content of a first word corresponding to a first address, the memory automatically supplies, at the data output terminal, a second binary information item represented by the content of a second word of the memory.

3. Method according to Claim 2, characterised in that the decoding of the address of the second word takes place when the binary information item represented by the content of the first word is supplied at the data output terminal.

4. Method according to one of Claims 2 to 3, characterised in that, in sequential read mode, one binary information item is extracted at a time.

5. Integrated circuit memory (1), organised in words (W0 to W255), the content of each word representing a binary information item (DATA), each word being accessible at a particular address (ADD) coded in binary over k bits, k being an integer greater than 1, the memory comprising:

- an address input terminal (2) for receiving the address bits serially,

- a data output terminal (3) for supplying the binary information items corresponding to the contents of the words address,

- an input register (RI) for storing address bits received,

- circuits (LD, CD) for decoding the address bits received,

- circuits (MUX1, MUX2) for connecting words to read circuits (SA1, SA2),

characterised in that

- the words are organised in groups of words (M1, M2) in such a way that the words in each group have k-q identical last address bits, with q an integer less than k, and q distinct first address bits,

- each group of words has an associated read circuit for, when the memory receives k address bits, extracting the binary information item represented by the content of the word of the group corresponding to the first q address bits received, and

- the memory comprises control (CC) and output multiplexing (MUXS) circuits for supplying, at the data output terminal, the binary information represented by the content of the word whose address corresponds to the k bits received.

6. Memory according to Claim 5, characterised in that the input register (R1) is formed by two shift sub-registers (RI1, RI2) formed respectively by q and k-q cells.

7. Memory according to Claim 6, characterised in that the input register (RI) is a binary address counter.

8. Memory according to Claim 7, characterised in that the control circuit (CC) comprises means for modifying the content of the input register (RI).

9. Memory according to one of Claims 5 to 8, characterised in that it comprises an output register (RO) connected to the read circuits (SA1, SA2) for storing the binary information items extracted by these read circuits.

10. Memory according to one of Claims 5 to 9, characterised in that it is an electrically programmable and erasable memory.

**Patentansprüche**

1. Verfahren zum Lesen des Inhalts von Worten in einem Speicher (1) in einem integrierten Schaltkreis, wobei dieser Speicher matrixförmig in Worte (WO bis W255) unterteilt ist, wobei der Inhalt jedes Wortes einer binären Information (DATA) entspricht, wobei auf jedes Wort über eine eigene Adresse (ADD) zugegriffen werden kann, die binär in k Bits kodiert ist, wobei k eine ganze Zahl größer als 1 ist, wobei die Adreßbits seriell durch den Speicher über einen Adreßeingangsanschluß (2) empfangen werden, dadurch gekennzeichnet, daß das Lesen des Inhalts eines Wortes die folgenden Schritte umfaßt:

- serieller Empfang von q ersten Adreßbits des zu lesenden Wortes, wobei q eine ganze Zahl kleiner als k ist,

- parallel zum Empfang der k - q letzten Adreßbits:

  - Dekodieren von q ersten empfangenen Adreßbits und Verbindung der Leseschaltkreise (SA1, SA2) mit den Worten, deren erste q Adreßbits den ersten q empfangenen Adreßbits entsprechen,

  - Extraktion von binären Informationen, die die Inhalte der besagten Worte darstellen,

  - Dekodieren von k - q letzten Adreßbits des zu lesenden Wortes und Ausgabe über einen Datenausgangsanschluß (3) des Speichers von binärer Information, die den Inhalt des Wortes darstellt, dessen Adreßbits den k empfangenen Adreßbits entsprechen.

2. Verfahren nach Anspruch 1, dadurch gekennzeichnet, daß der Speicher einen Lesemode aufweist, der sequentiell genannt wird, bei dem nach dem Lesen des Inhaltes eines ersten Wortes, das einer ersten Adresse entspricht, der Speicher automatisch über den Datenausgangsanschluß eine zweite binäre Information ausgibt, die den Inhalt des zweiten Wortes des Speichers wiedergibt.

3. Verfahren nach Anspruch 2, dadurch gekennzeichnet, daß die Dekodierung der Adresse des zweiten Wortes stattfindet bei der Ausgabe über den Datenausgabeanschluß von binärer Information, die den Inhalt des ersten Wortes darstellt.

4. Verfahren nach einem der Ansprüche 2 oder 3, dadurch gekennzeichnet, daß bei dem sequentiellen Lesemode gleichzeitig eine binäre Information extrahiert wird.

5. Speicher (1) in einem integrierten Schaltkreis, der in Worte (W0 bis W255) unterteilt ist, wobei der Inhalt jedes Wortes eine binäre Information (DATA) darstellt, wobei auf das Wort an einer eigenen Adresse (ADD) zugegriffen werden kann, die binär in k Bits kodiert ist, wobei k eine ganze Zahl größer als 1 ist, wobei der Speicher umfaßt:

- einen Adresseneingangsanschluß (2), um seriell die Adreßbits zu empfangen,

- einen Datenausgangsanschluß (3), um binäre Informationen auszugeben, die den Inhalten der adressierten Worte entsprechen,

- ein Eingangsregister (RI), um die empfangenen Adreßbits zu speichern,

- Dekodierungsschaltkreise (LD, CD) für die empfangenen Adreßbits,

- Verbindungsschaltkreise (MUX1, MUX2) für die Worte mit den Leseschaltkreisen (SA1, SA2),

dadurch gekennzeichnet, daß

- die Worte in Gruppen von Worten (M1, M2) so unterteilt sind, daß die Worte jeder Gruppe k - q letzte identische Adreßbits, wobei q eine ganze Zahl kleiner als k ist, und q erste unterschiedliche Adreßbits aufweisen,

- jede Gruppe von Worten einen dazugehörigen Leseschaltkreis hat, um, wenn der Speicher k Adreßbits empfängt, binäre Information zu extrahieren, die den Inhalt des Wortes der Gruppe darstellt, die den q ersten empfangenen Adreßbits entspricht, und

- der Speicher Steuerschaltkreise (CC) und Ausgangsmultiplexer (MUXS) umfaßt, um über den Datenausgangsanschluß binäre Information auszugeben, die den Inhalt des Wortes darstellt, dessen Adresse den empfangenen k Bits entspricht.

6. Speicher nach Anspruch 5, dadurch gekennzeichnet, daß das Eingangsregister (RI) zwei Unterschieberegister (RI1, RI2) mit jeweils q bzw. k - q Zellen umfaßt.

7. Speicher nach Anspruch 6, dadurch gekennzeichnet, daß das Eingangsregister (RI) ein binärer Adressenzähler ist.

8. Speicher nach Anspruch 7, dadurch gekennzeichnet, daß der Steuerschaltkreis (CC) Vorrichtungen umfaßt, um den Inhalt des Eingangsregisters (RI) zu modifizieren.

9. Speicher nach einem der Ansprüche 5 bis 8, dadurch gekennzeichnet, daß er ein Ausgangsregister (RO) umfaßt, das mit den Leseschaltkreisen (SA1, SA2) verbunden ist, um die von den Leseschaltkreisen extrahierten binären Informationen abzuspeichern.

10. Speicher nach einem der Ansprüche 5 bis 9, dadurch gekennzeichnet, daß er ein elektrisch programmierbarer und löschbarer Speicher ist.

# FIG_1

EP 0 712 133 B1

# FIG_2